# EUROPEAN PATENT APPLICATION

(11) **EP 1 048 759 A1**
(43) Date of publication of application: **02.11.2000**
(21) Application number: 00108493.8
(22) Date of filing: 19.04.2000
(51) Int. Cl.: C30B 11/00, C30B 29/52, B22D 27/08

(54) **Horizontal directional solidification**

(30) Priority: 28.04.1999 US 301229; 28.04.1999 US 301423
(71) Applicant: Howmet Research Corporation, Whitehall, Michigan 49461 (US)
(72) Inventor: Brinegar, John R., Muskegon, Michigan (US)
(74) Representative: Hoeger, Stellrecht & Partner

(57) **Abstract**

Method and apparatus for directional solidification of molten metal using a general horizontally oriented mold initially positioned in a casting furnace. The mold is filled with molten metal and then withdrawn from the casting furnace to effect directional solidification. As the molten metal solidifies in the mold, the mold is turned about a general horizontal axis to reduce segregation of alloying elements in the solidifying molten metal.

## Description

The present invention relates to horizontal directional solidification of molten metals.

Directional solidification of molten metal using a vertically oriented ceramic mold positioned on a horizontal chill plate is well known in the art of investment casting to produce such components as columnar grain or single crystal gas turbine engine blades and vanes. Typically, the vertically oriented mold on the chill plate is filled with molten metal in an upstanding casting furnace, and then the chill plate and mold are vertically withdrawn from the casting furnace to establish unidirectional heat removal from the molten metal in the mold to produce a columnar or single crystal casting microstructure if a crystal selector passage (e. g. pigtail) is provided on the mold.

It is an object of the present invention to provide a method and an apparatus for directional solidification with reduced segregation of alloying elements in the solidifying molten metal.

A further object of the present invention is to provide a method and an apparatus for directional solidification which allows fabrication of molds with mold walls which are thinner than the mold wall thickness used for investment casting with the mold oriented vertically.

These objects are achieved by the method of claim 1 and the apparatus of claim 21, respectively.

Further improvements are defined by claims 2 to 20 and 22 to 40.

Preferred embodiments of the present invention make use of molds having a mold cavity with a width and a length, said length being measured in the direction of the mold axis and being greater than said width.

Preferably, the mold axis is generally horizontally oriented.

The present invention provides in an embodiment a method and an apparatus for directional solidification of molten metal using a generally horizontally oriented mold initially positioned in a casting furnace. The mold is filled with molten metal through a mold pour cup located on an initially upper region of the mold and a pour cup runner that enters the mold at a melt entry. The melt filled mold initially is withdrawn from the casting furnace to solidify the molten metal at the location where the pour cup runner enters the mold. The melt filled mold then is withdrawn while the mold is rotated about its generally horizontal axis to reduce segregation of alloying elements in the solidifying molten metal. Initial solidification of molten metal at the entry of the pour cup runner to the mold prevents molten metal from flowing out of the mold through the pour cup when the mold is subsequently rotated.

In another embodiment of the present invention, the generally horizontally oriented mold is filled with molten metal through a mold pour cup located on an initially upper region of the mold. The melt filled mold is withdrawn from the casting furnace to effect directional solidification. As the melt filled mold is withdrawn, the mold is oscillated about a generally horizontal axis within an oscillation angular range of up to about 180 degrees. Such limited angle oscillation during mold withdrawal reduces segregation of alloying elements in the solidifying molten metal and prevents molten metal from flowing out of the mold through the pour cup.

The above and other objects and advantages of the present invention will become more readily apparent from the enclosed drawings taken in conjunction with the following detailed description.
Fig. 1 shows a schematic view, partially in section, of a directional solidification apparatus pursuant to an embodiment of the invention.
Fig. 2A is a schematic sectional view along line 2-2 of Fig. 1 showing rotational motion of the mold, and
Fig. 2B is a schematic sectional view along line 2-2 of Fig. 1 showing limited angle mold oscillation.

Referring to the drawings, illustrative embodiments of the present invention involve method and apparatus for directional solidification of molten metal using a general horizontally oriented refractory mold 10 initially positioned to reside in a casting furnace 14, said mold being at least initially in contact with a metal chill 12 positioned outside the furnace 14. By generally horizontal is meant that the mold 10 can reside with its longitudinal mold axis M in a horizontal plane or near horizontal plane where the mold axis M is slightly inclined from horizontal by preferably up to 45 degrees for embodiments wherein the mold is rotated, and by preferably up to 30 degrees for embodiments wherein the mold is oscillated back and forth through a limited angle of rotation up to about 180 degrees about the longitudinal mold axis.

The mold 10 can comprise a conventional ceramic investment shell mold made by repeatedly dipping a fugitive (e. g. wax) pattern of the article to be cast in ceramic slurry, draining excess slurry, and stuccoing the slurry-coated pattern with ceramic stucco particulates to build up a shell mold of desired mold wall thickness on the pattern. The pattern is removed thermally, such as melting, dissolution or other means to leave a ceramic shell mold which is fired at elevated temperature prior to casting to develop suitable mold strength for casting.

The ceramic shell mold 10 can be formed to include not only an article-forming mold cavity 10a, but also a grain starter chamber 10b, and a grain or crystal selector passage 10c communicating the grain starter chamber to the mold cavity 10a to select a single grain to propagate from the grain starter chamber 10b through the mold cavity 10a to from a single crystal casting therein. Alternately, the passage 10c may be omitted to form columnar grain castings whereby the grain starter chamber 10b communicates directly to the mold cavity 10a.

The shell mold 10 includes an integral or attached pour cup 10e that is communicated to the mold cavity 10a to introduce molten metal into the mold 10 to fill mold cavity 10a, grain starter chamber 10b, and passage 10c with molten metal. The pour cup includes an enlarged top cup 10p that receives molten metal from a crucible or other melting or melt-holding vessel 20 and an elongated pour cup runner passage 10n that preferably communicates to the mold cavity 10a proximate the passage 10c (or chamber 10b for columnar grain castings), although the runner passage 10n can communicate with the mold interior at other locations, such as mold cavity 10a depending on geometry of the casting to be made. The pour cup 10e is shown located on an upper region of the shell mold and extending outside of the casting furnace 14 to receive molten metal from the melting or meld-holding vessel 20. Alternately, the pour cup 10e can be connected to an upper region of the mold 10 within the furnace 14 if molten metal can be supplied to the pour cup within the furnace.

The shell mold 10 includes flange 10f that is clamped by clamps (not shown) on the chill 12, which can comprise water cooled copper chill plate oriented vertically as shown. The chill plate 12 is connected to a ram 16 that is moved parallel to the mold axis M and preferably horizontally (axially) and also is rotated 360 degrees or oscillated back and forth through a limited angle of rotation up to about 180 degrees about its longitudinal and preferably horizontal axis A by a suitable combination of linear and rotary or oscillating rotary fluid, electric or other actuators shown schematically at 17a and 17b. For example, a rotary actuator or an oscillating rotary actuator can be mounted on a linear slide actuator to achieve the linear and rotary or oscillation motion of the ram 16. Alternatively, the furnace may be moved horizontally by a suitable actuator while the chill plate and mold are turned, i. e. oscillated through a limited angle of rotation or rotated.

The casting furnace 14 comprises an inner tubular graphite susceptor 14a that is heated by energization of an induction coil 22 disposed about the furnace 14. The furnace includes a refractory sleeve 14b surrounding the susceptor 14a and an end closure 14c to close off the end of the furnace. A preferably annular heat baffle 14d is disposed at the other end of the furnace 14 where the mold 10 is withdrawn on chill plate 12 by axial movement of ram 16 to enhance the thermal gradient in the molten metal as the mold 10 is withdrawn from the furnace 14.

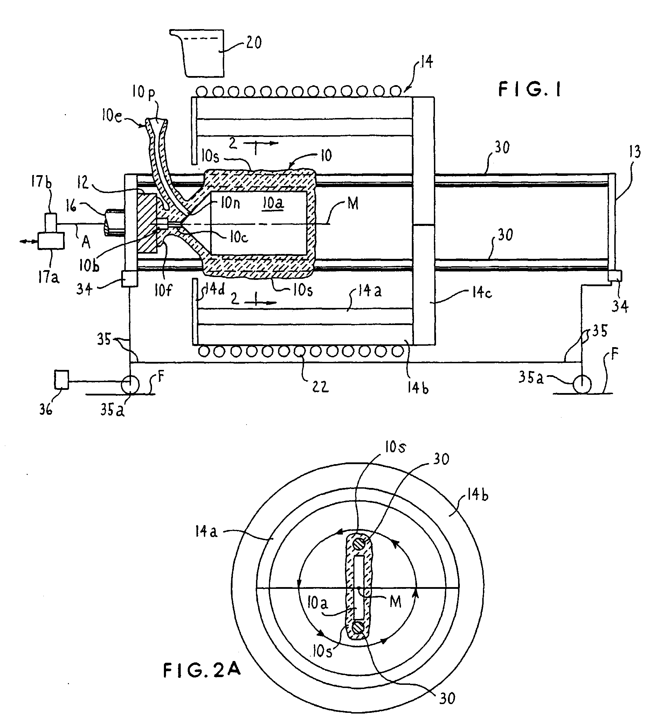

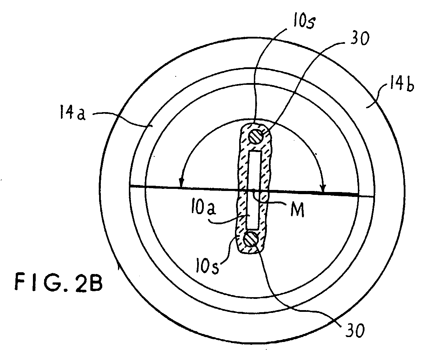

In embodiments wherein the mold 10 is rotated 360 degrees about the mold axis M, directional solidification is effected by filling the generally horizontally oriented mold 10 residing on the chill plate 12 as shown in Fig. 1 with molten metal via the pour cup 10e. In accordance with the invention, the melt filled mold 10 is initially gradially withdrawn horizontally (or in the direction of an inclined mold axis M) without mold rotation from the furnace 14 by axial movement of the ram 16 past the heat baffle 14d to achieve solidification of the molten metal in the grain starter chamber 10b (for columnar grain casting) or grain selection passage 10c (for single crystal casting) and at the entry location of the pour cup runner passage 10n into the mold. Thereafter, the melt filled mold 10 is rotated 360 degrees about the mold axis M and coaxial ram axis A during remaining mold withdrawal as indicated by the arrow in Fig. 2A to reduce segregation of alloying elements in the solidifying molten metal. The initial solidification of the molten metal in chamber 10b or passage 10c and/or at the entry location of runner passage 10n into the mold prevents molten metal in the mold 10 from inadvertantly flowing out of the mold through the pour cup 10e during mold rotation. Such simultaneous ram axial movement and rotation can be conducted while the melt filled mold 10 is supported on a pair of parallel rods 30 that extend through longitudinal passages formed in side flanges 10s of the mold.

In embodiments wherein the mold is oscillated within a limited angular range, directional solidification is effected as follows: The preferably generally horizontally oriented mold 10 residing on the chill plate 12 is filled with molten metal via the pour cup 10e. The melt filled mold 10 then is gradually withdrawn generally horizontally from the furnace 14 by axial movement of the ram 16 past the heat baffle 14d to achieve propagation of one or more grains from the starter chamber 10b (and as the case may be, through the passage 10c) and through the mold cavity 10a to form a single crystal or columnar grain casting in the mold cavity 10a. In accordance with the invention, the melt filled mold 10 is oscillated about the general horizontal mold axis M and coaxial ram axis A within a angular range of up to about 180 degrees during mold withdrawal as indicated by the arrow in Fig. 2B to reduce segregation of alloying elements in the solidifying molten metal and also to prevent molten metal in the mold 10 from inadvertantly flowing out of the mold through the pour cup 10e. This mold oscillation is achieved by simultaneously oscillating ram 16 by actuator 17b while the ram is being moved axially by actuator 17a to withdraw the mold 10 from the furnace. Also such simultaneous ram axial movement and oscillatory movement can be conducted while the melt filled mold 10 is supported on the pair of parallel rods 30.

The rods 30 are fastened at one end to chill plate 12, or other plate, on the ram by any suitable fastening means and to another end plate 13 by any suitable fastening means with the plates 12, 13 positioned for rotation or oscillation on bushings or bearings 34 on a linear traveling carriage 35 that is moved linearly with the ram 16 by any suitable actuator 36 to follow linear movement of the ram 16. The end closure 14c includes apertures for receiving the rods 30. The carriage 35 includes wheels 35a that ride on a support floor F.

The melt filled mold 10 is withdrawn axially from the furnace 14 and rotated or oscillated (through the limited angle) until the molten metal in mold cavity 10a is solidified to have a desired columnar grain or single crystal microstructure. A withdrawal rate and revolution speed or oscillation rate can be selected as desired to reduce segregation while unidirectionally solidifying the melt in the mold 10.

In accordance with the present invention, the mold 10 can be fabricated with a mold wall that is thinner than the mold wall thickness used for investment casting with the mold oriented vertically because of a reduction in metallostatic head or pressure in the generally horizontal melt-filled mold 10. For example, an investment casting mold for an industrial gas turbine engine plate can be 4 feet tall when oriented vertically for casting but is only 1 foot tall when oriented horizontally on its side for casting to reduce molten metallostatic pressure on the mold during casting.

The definition that the mold is turned about the mold axis as the molten metal solidifies in the mold cavity means that the mold is turned over the entire solidification period or part of said period.

Basically, the melt entry of the mold can be closed by any suitable means, but preferably by solidified metal.

The pour cup must be designed and positioned so that it allows rotation or oscillation of the mold.

As shown in Fig. 1, it is not necessary that the entire mold with its pour cup and grain starter chamber resides initially within the casting furnace.

It has been shown that, according to an embodiment of the present invention, the method of directional solidification of a molten metal comprises relatively moving a molten metal filled generally horizontally oriented mold and a casting furnace to solidify molten metal proximate a pour cup entry to the mold and then relatively moving said mold and said furnace while rotating said mold about a generally horizontally oriented mold axis.

According to another embodiment of the present invention, the method of directional solidification of molten metal comprises relatively moving a molten metal filled generally horizontally oriented mold and a casting furnace to effect directional solidification of the molten metal in the mold and oscillating the mold about a general horizontal mold axis up to about 180 degrees as the mold and the furnace are relatively moved.

## Claims

1. A method of directional solidification of molten metal, comprising providing a mold (10) having a mold cavity (10a), a casting furnace (14) for receiving said mold, and means (17a) for relatively moving said mold and said furnace, wherein said furnace (14) and said mold (10) with molten metal filled mold cavity (10a) are translatorily relatively moved so as to effect directional solidification of the molten metal in the mold, and wherein the mold is turned about a mold axis (M) as the molten metal solidifies in said mold cavity (10a), said mold axis (M) being inclined relative to vertical.

2. The method of claim 1, wherein said furnace (14) and said mold (10) are translatorily relatively moved as the mold is turned about said mold axis (M).

3. The method of claim 1 or 2, wherein, by said relative translatory movement, the mold (10) is progressively removed from the furnace (14) to progressively effect directional solidification.

4. The method of one of claims 1 to 3, wherein said mold cavity (10a) has a width and a length, said length being measured in the direction of said mold axis (M) and being greater than said width.

5. The method of one of claims 1 to 4, wherein said furnace (14) and said molten metal filled mold (10) are relatively moved in the direction of said mold axis (M).

6. The method of one of claims 1 to 5, wherein the mold (10) contacts a chill (12) as the mold is filled with molten metal or shortly thereafter.

7. The method of claim 6, wherein said mold (10) is in contact with said chill (12) while the furnace (14) and the mold are relatively moved.

8. The method of claim 6 or 7, wherein said mold (10) is in contact with said chill (12) while the mold is turned about said mold axis (M).

9. The method of claim 8, wherein said chill (12) is turned together with said mold (10).

10. The method of one of claims 1 to 9, wherein said mold (10) and said furnace (14) are relatively linearly moved.

11. The method of one of claims 1 to 10, wherein said furnace (14) and said mold (10) with molten metal filled mold cavity (10a) are translatorily relatively moved to solidify molten metal proximate a mold melt entry (10n) to said mold cavity, and wherein, following solidification of the molten metal proximate said melt entry, said mold is rotated about said mold axis (M).

12. The method of claim 11, wherein said mold axis (M) is horizontal or oriented up to 45 degrees relative to horizontal.

13. The method of claim 11 or 12, wherein said furnace (14) and said mold (10) are relatively moved while said mold is rotated.

14. The method of one of claims 1 to 10, wherein said mold (10) is oscillated about said mold axis (M) up to about 180 degrees as the molten metal solidifies in said mold (10).

15. The method of claim 14, wherein the mold (10) is oscillated as the mold and the furnace (14) are translatorily relatively moved.

16. The method of claim 14 or 15, wherein said mold axis (M) is horizontal or oriented up to 30 degrees relative to horizontal.

17. The method of one of claims 14 to 16, wherein said mold (10) has a melt entry (10n) to said mold cavity (10a) and is oscillated about such an angle that loss of melt through the melt entry is avoided.

18. The method of claim 11 or 17 including filling the mold cavity (10a) with molten metal as said melt entry (10n) is located on an upper region of the mold (10).

19. The method of one of claims 1 to 18, including providing a mold pour cup (10e) communicated to said mold cavity (10a) and located on an upper region of the mold (10) as the mold is filled with molten metal.

20. The method of claim 19, wherein said pour cup (10e) extends from the mold (10) to a position outside or inside the casting furnace (14) where the melt is introduced into the pour cup for flow into the mold (10) residing in the furnace.

21. Apparatus for directional solidification of molten metal comprising a mold (10) having a mold cavity (10a), a casting furnace (14) for receiving said mold, and means (17a) for relatively moving said mold and said furnace, said apparatus comprising a first actuator (17a) for translatorily relatively moving said mold (10) and said furnace (14), and a second actuator (17b) for turning the mold about a mold axis (M) as the molten metal solidifies in said mold (10), said mold axis (M) being inclined relative to vertical.

22. The apparatus of claim 21, wherein said second actuator (17b) is adapted to rotate said mold (10) about said mold axis (M).

23. The apparatus of claim 22, wherein said mold axis (M) is horizontal or oriented up to 45 degrees relative to horizontal.

24. The apparatus of claim 21, wherein said second actuator (17b) is adapted to oscillate said mold (10) about said mold axis (M) up to 180 degrees.

25. The apparatus of claim 24, wherein said mold axis (M) is horizontal or oriented up to 30 degrees relative to horizontal.

26. The apparatus of one of claims 21 to 25, wherein said first actuator (17a) is adapted to relatively linearly move the furnace (14) and the mold (10).

27. The apparatus of claim 26, wherein said first actuator (17a) is adapted to relatively move the furnace (14) and the mold (10) in the direction of said mold axis (M).

28. The apparatus of one of claims 21 to 27, wherein said mold cavity (10a) has a width and a length, said length being measured in the direction of said mold axis (M) and being greater than said width.

29. The apparatus of one of claims 21 to 28 and comprising a chill (12) for being contacted by said mold (10).

30. The apparatus of claim 29, wherein said chill (12) is located outside of the casting furnace (14).

31. The apparatus of claim 29 or 30, wherein said chill (12) is connected to a ram (16).

32. The apparatus of one of claims 29 to 31 and comprising means for relatively linearly moving the furnace (14) and the mold (10) with chill (12).

33. The apparatus of one of claims 29 to 32 and comprising means for turning the chill (12) together with the mold (10).

34. The apparatus of one of claims 21 to 33, wherein the mold (10) includes a pour cup (10e) communicated to a mold melt entry (10n) to said mold cavity (10a), said pour cup being initially located at an upper region of the mold.

35. The apparatus of claim 34, wherein said pour cup (10e) extends from the mold to a position outside the casting furnace (14) where the melt is introduced into the pour cup for flow into the mold residing in the furnace.

36. The apparatus of one of claims 21 to 35, wherein the mold (10) has a melt entry (10n) to said mold cavity (10a) and a grain starter chamber (10b) communicated to said mold cavity (10a) and being proximate said melt entry.

37. The apparatus of claim 36, wherein said mold axis (M) traverses the mold (10) at opposite ends of the mold, said grain starter chamber (10b) being proximate one of said mold ends.

38. The apparatus of claims 29 and 37, wherein said one mold end is proximate said chill (12).

39. The apparatus of one of claims 36 to 38, wherein the mold (10) has a grain selector passage (10c) between said grain starter chamber (10b) and said mold cavity (10a).

40. The apparatus of claim 39, wherein said melt entry (10n) is proximate said grain selector passage (10c).
